# EUROPEAN PATENT APPLICATION

(11) **EP 0 911 117 A2**
(43) Date of publication of application: **28.04.1999**
(21) Application number: 98307687.8
(22) Date of filing: 22.09.1998
(51) Int. Cl.: B25B 9/00

(54) **Hand tool for manipulating recticle plate**

(30) Priority: 27.10.1997 US 958465
(71) Applicant: Hewlett-Packard Company, Palo Alto, California 94304 (US)
(72) Inventor: Dille, David H., Corvallis OR 97330 (US)
(74) Representative: Colgan, Stephen James

(57) **Abstract**

A tool (10) for grasping a rectangular plate (12), and having a handle (10) and a pair of spaced apart grip elements (24, 26) connected to the handle. A movable frame (32) is connected to the handle and moves relative to the handle. A second pair of spaced apart grip elements (44, 46) are connected to the movable frame, and are spring biased toward the first pair. A trigger (40) is connected to the frame near the handle, so that the second pair of grip elements may be moved toward and away from the first pair in response to movement of the trigger, to grasp and release a rectangular plate between the grip elements.

## Description

### Field of the Invention

This invention relates to hand tools, and more particularly to tools for grasping and carrying precision reticle or mask plates used in semiconductor imaging processes.

### Background and Summary of the Invention

Reticle or mask plates are used in semiconductor imaging in the manner of photographic negatives used to make photographic prints. Reticles are quartz plates, typically square, 5-6 inches on a side, and imaged on one surface with a chrome pattern corresponding to a desired image of a selected layer of a semiconductor chip on a wafer. A pellicle layer is provided by a transparent film spaced above the chromed surface, with an air gap between the reticle and pellicle to prevent particles from alighting on the image plane. Small particles on the pellicle film will be sufficiently out of the focal plane as to be tolerable.

Reticles are fragile and costly, so that extreme care is required in their handling. The pellicle film is particularly fragile; almost any inadvertent contact may damage or destroy the film, necessitating replacement of the film. Thus, human contact with the reticle is generally avoided, and many operations involving reticles are automated. Nonetheless, certain operations, such as placing reticles in their carrier trays or boxes, or removing them, requires a manual operation. To reduce the risk of damaging contact by fingers, or dropping of the reticles, reticle picks have been employed. These tools grab the reticle at its edges, either at the center of opposed end edges, or at broad portions of opposed end edges near one side edge. Those tools that grab at the center of opposed edges risk damaging the pellicle, which is only slightly spaced away from the reticle edge. Those that grab at opposed locations offset from the centerline must have broad jaws to provide stability against the torque presented by the offset load, and suffer from the same risk of pellicle damage. In addition, existing tools are configured with release triggers poorly positioned for convenient operation, and with linkages that prevent a positive feel to enable an operator to receive clear tactile feedback when manipulating a reticle.

Therefore, there exists a need for a tool for grasping a rectangular plate, and having a handle and a pair of spaced apart grip elements connected to the handle. A movable frame is connected to the handle and moves relative to the handle. A second pair of spaced apart grip elements are connected to the movable frame, and are spring biased toward the first pair. A trigger is connected to the frame near the handle, so that the second pair of grip elements may be moved toward and away from the first pair in response to movement of the trigger, to grasp and release a rectangular plate between the grip elements.

### Brief Description of the Drawings

Fig. 1 is a perspective view of a tool according to a preferred embodiment of the invention.

Fig. 2 is a side view of the tool of Fig. 1.

Fig. 3 is a top view of the tool of Fig. 1.

Fig. 4 is a top view of a reticle plate suitable for use with the tool of Fig. 1.

Fig. 5 is a sectional side view of the reticle plate of Fig. 4 and portions of the tool of Fig. 1.

Fig. 6 is a front end view of the reticle plate of Fig. 4 and portions of the tool of Fig. 1.

### Detailed Description of a Preferred Embodiment

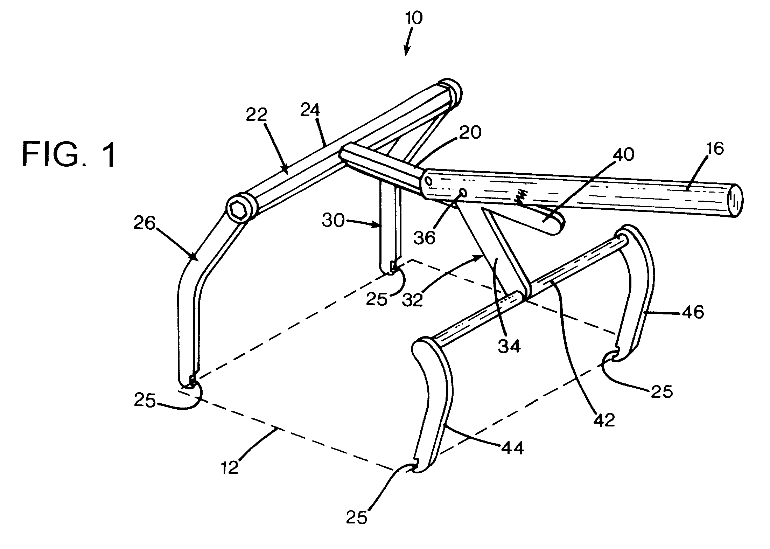

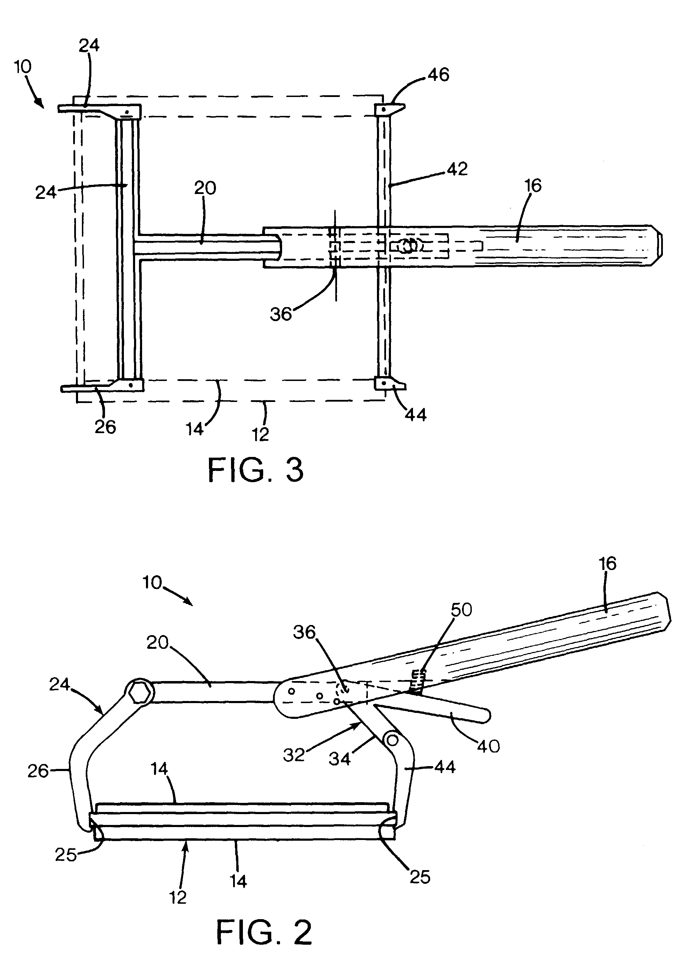

Figures 1 and 2 show a reticle hand tool 10 for engaging a reticle plate 12. As the tool is intended to be used to maintain the reticle in a horizontal plane, this disclosure will be made in the context of the illustrated frame of reference. The tool has a fixed frame portion and a movable frame portion that operate to grasp and release the reticle.

The fixed frame portion includes an elongated handle 16 extending rearward toward a user, an elongated central rib 20 extending horizontally from the forward end of the handle, and a fixed jaw assembly 22 attached to the forward free end of the rib 20 opposite the handle. The handle 16 extends about ten degrees upward from horizontal so that its free end is elevated above the rib, for user comfort and control of the tool. The fixed jaw assembly includes a cross bar 24 attached at its middle to the end of the rib 20, and extending perpendicularly to the rib in a horizontal plane. A first pair of dog leg shaped first blades 26, 30 depend generally downward from the ends of the cross bar 24 in parallel to each other. Each blade has an upper portion extending at an angle downward and forward from the cross bar, and a lower portion extending downward and slightly inward in the direction of the handle. At the lower ends of the blades, a gripping notch 31 is defined in the surface that faces rearward to accommodate the edge of the reticle.

The entire fixed frame portion is formed or assembled as a rigid unit, with aluminum being a preferred material, except for the handle, which is formed of a moderately electrically conductive carbon-loaded thermoplastic to controllably bleed any electrostatic discharges that may accumulate on the reticle.

The movable frame portion pivots with respect to the fixed frame portion. A pivot member 32 is an acutely angled bell crank with a V-shaped profile. A first leg 34 extends downward and rearward from a pivot point 36, and a second leg or trigger portion 40 extends mostly rearward and slightly downward form the pivot point. The handle defines a channel in its lower surface to receive the vertex of the pivot member. A horizontal cross bar 42 is attached to the lower end of the first leg, and a pair of blades 44, 46 extend downward from the ends of the cross member. An upper portion of each leg extends parallel to the first leg 34, as shown in Figure 2, and a lower portion extends downward and slightly forward. At the end of each blade, a gripping notch 25 faces the gripping notch of the corresponding of the fixed blades.

As shown in Fig. 2, a compression spring 50 is captured in the handle recess to bias the trigger away from the handle and move the rear jaw to the closed position (shown in solid lines). The trigger may readily be actuated by the index finger of a user. Carrying and trigger actuation may easily be done with only one hand, freeing the user's hand for other purposes. For a secure grip, the user's thumb may grip the handle, and is not required for trigger operation. When squeezed, the trigger moves into a recess in the handle, and the blades 44, 46 move to an open position (dashed lines.) In the open position, the spacing between the opposed jaws is enlarged, permitting the tool to be positioned about or removed from the reticle.

As shown in Figure 3, the blades of each jaw are spaced widely apart to engage near the corners of the reticle 12. The spacing between each pair of blades is the same, so that each blade occupies a common vertical plane with the opposed blade.

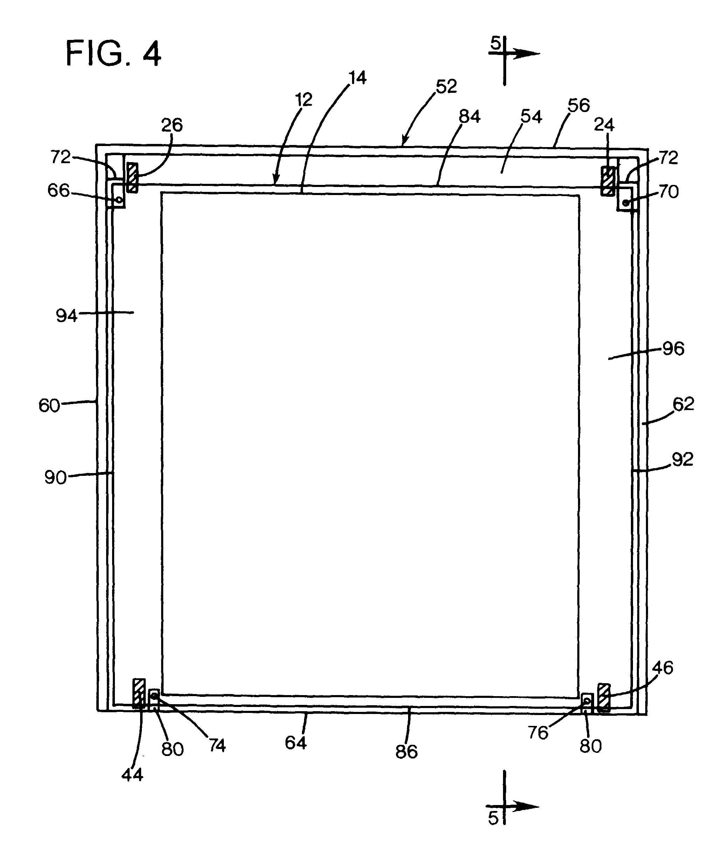

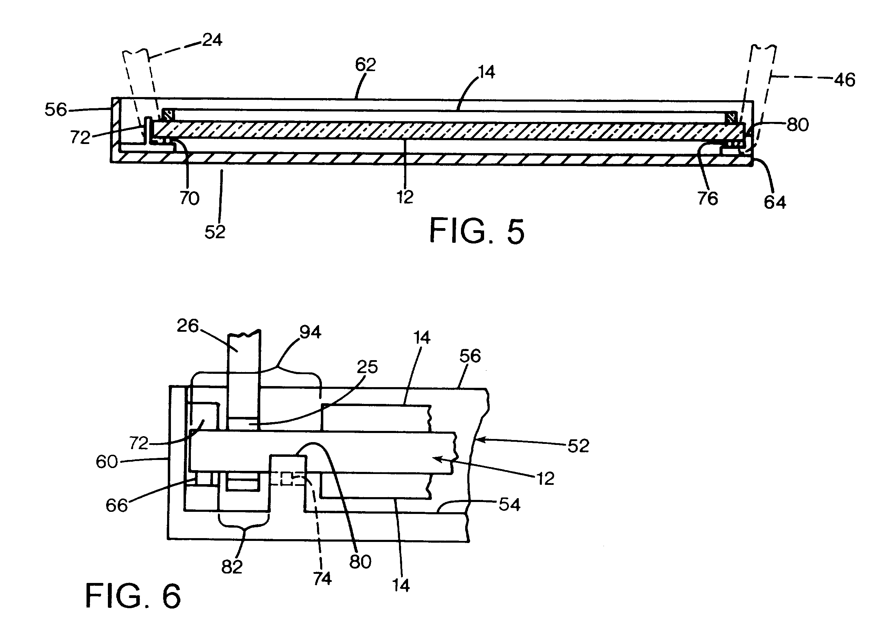

As shown in Figure 4, the reticle 12 is normally carried in a protective box or tray 52 having a flat bottom 54, a rear wall 56, left side wall 60, and right side wall 62. A front edge 64 of the tray lacks a peripheral wall, permitting access by the tool 10, and by forklift-type robotic implements. Near each corner of the tray, a standoff rises above the floor to support a corner of the reticle so that the lower surface or a lower pellicle layer does not contact the floor. Each rear standoff 66, 70 has a small pin rising from a plinth on the floor, and is contiguous with a side wall. As shown in Fig. 5, a back stop stanchion 72 connected to an associated side wall is spaced apart from the rear wall to keep the reticle sufficiently far from the rear wall to permit the tool blades 24, 26 to be inserted between the rear edge of the reticle and the rear wall without interference.

A pair of front standoffs 74, 76 are located at the front edge of the tray, and have short risers 80 that extend only slightly above the level of the standoff pins, preventing the reticle from sliding out of the tray, but allowing a low threshold over which the reticle must be lifted for insertion and removal from the tray. The front standoffs are each spaced apart from the side walls, so that robotic lift forks may be inserted below the reticle on each side outboard of the front standoffs, and so that the tool jaws 44 and 46 may also be positioned just outside of the front standoffs, while the rear jaws remain between the rear standoffs, as shown in Fig. 6. The apparent space 82 between the front and rear standoffs, as viewed from the front, is defined as the difference between the distances by which the right side of the rear standoff plinth and the left side of the front standoff plinth are separated from the interior surface of the left side wall 60. The blades have a thickness only somewhat less than this space, so that the standoffs effectively guide the blades to a desired and controlled position for picking up the reticle from the tray. Note that blade 44 is omitted for clarity in Figure 6.

Returning to Figure 4, the reticle is a conventional type, 6.0 inches (152mm) on a side, and with a quartz plate 6.5mm thick. Smaller reticles may be thinner, making them lighter and more easily to manipulate by hand, however the size and weight of the illustrated reticle necessitates the disclosed tool. The pellicle 14 is a thin film layer suspended by a gasket about 4mm from the reticle surface on one or both sides of the reticle. The pellicle is spaced apart from the edges of the reticle by various margins, at a rear edge 84 of the reticle by 2mm, at a front edge 86 by 1mm, and at side edges 90, 92 by 10-15mm. The larger setback at the side edges provides a broad margin strip 94, 96 along each side edge. The margin strips extend from the front edge to the back edge, and are wide enough the ensure that the standoff, tool jaws, and lift forks all interact with the reticle only at the margin strips. The most medial potential obstacle, the front standoffs 74, 76, are safely positioned laterally of the pellicle. Because the reticle is sized to be closely received between the side walls 60, 62 of the tray, minimal play is permitted, and a safe separation between the pellicle and the various potential obstacles is maintained.

In the preferred embodiment, the front and rear standoffs are about 2-3 mm wide, and the space 82 is 2-3 wide, providing a total of 6-9 mm. With a 10-15 mm wide margin strip on each side, the pellicle is protected. Because the tool's blades are about 2-3 mm thick they are well constrained by the front and rear standoffs. In the absence of this ensured registration with the safe margins, there would be a risk that the jaws may slip off the reticle edge, and bite into the edge of the pellicle. By keeping the jaws to the sides, even such slippage would not endanger the pellicle.

The handle and body of the tool are spaced well above the ends of the blades, providing a clearer view by the user to ensure that the tool is properly positioned above the reticle for engagement. The long legged design also keeps the central portions of the tool a safe distance above the pellicle. In addition, the wide spacing of the blades enhances visibility by reducing obstructions above the reticle. While the above is discussed in terms of preferred and alternative embodiments, the invention is not intended to be so limited.

## Claims

1. A tool (10) for grasping a rectangular plate (12), the tool comprising:
a handle (16);
a first pair of spaced apart grip elements (26, 30) connected to the handle;
a movable frame (32)connected to the handle and movable relative thereto;
a second pair of spaced apart grip elements (44, 46) connected to the frame;
the second pair being spring biased toward the first pair; and
a trigger (40) connected to the frame and proximate to the handle, such that the second pair of grip elements may be moved toward and away from the first pair in response to movement of the trigger to grasp and release a rectangular plate between the grip elements.

2. A tool according to claim 1 wherein the grip elements (25) of at least one of the pairs is spaced apart by at least five inches such that a standard reticle may be grasped near its corners.

3. A tool according to claim 1 or claim 2 wherein each of the pairs are spaced apart by a common spacing, such that each of the grip elements opposes a corresponding grip element.

4. A tool according to any one of claims 1 to 3 wherein the grip elements (25) are arranged in a rectangular array having a limited aspect ratio, such that the grip elements contact near the corners of a square plate.

5. A tool according to any one of claims 1 to 4 wherein the second pair (44, 46) is rigidly connected to the trigger.

6. A tool according to any one of claims 1 to 5 wherein each of the grip elements (25) is at the free end of a respective arm (26, 30, 44, 46).

7. A tool according to any one of claims 1 to 6 wherein each of the grip elements is substantially narrower that the spacing between each pair of grip elements.

8. A method of manipulating a reticle (12) having a pellicle (14) spaced apart from at least some of the edges of the reticle by a margin, the method comprising the steps:
providing a tool (10) having a plurality of grip elements (25), at least some of which are movable;
positioning the tool with a respective one of the grip elements proximate to the corner of the reticle;
contacting the reticle with a grip element contacting each end of each of the marginal strips, such that the grip elements are spaced apart from the pellicle; and
biasing the grip elements toward the reticle to retain the reticle.

9. A method according to claim 8 wherein the reticle is retained in a tray (52) having support elements (66, 70, 74, 76) proximate the corners of the reticle, and wherein positioning the tool includes positioning the grip elements (25) proximate the support elements.

10. A method according to claim 8 or claim 9 wherein positioning the tool includes applying a force to overcome a spring bias, and wherein biasing the grip elements includes releasing the force.
